# EUROPEAN PATENT APPLICATION

(11) **EP 1 132 950 A1**
(43) Date of publication of application: **12.09.2001**
(21) Application number: 99947960.3
(22) Date of filing: 19.10.1999
(51) Int. Cl.: H01L 21/205

(54) **WAFER SUPPORT OF SEMICONDUCTOR MANUFACTURING SYSTEM**

(30) Priority: 19.10.1998 JP 29708798
(71) Applicant: Applied Materials, Inc., Santa Clara, California 95054 (US)
(72) Inventor: ARIMURA, Kenichi, Narita-shi Chiba 286-8516 (JP); ARIMA, Seiji, Narita-shi Chiba 286-8516 (JP); TAKAGI, Youji, Narita-shi Chiba 286-8516 (JP)
(74) Representative: Draper, Martyn John
(86) International application number: JP9905753
(87) International publication number: WO0024044

(57) **Abstract**

An epitaxial growth apparatus comprises a process chamber of silica glass, and a wafer support disposed within the chamber. Halogen lamps are disposed below and above the process chamber, and are adapted to heat a semiconductor wafer supported by the wafer support. The wafer support comprises a susceptor for mounting the wafer, and a susceptor support shaft for supporting the susceptor from thereunder. Arms for supporting the susceptor by three points radially extend from the main shaft of the susceptor support shaft. Since the center portion of the lower surface of susceptor has no supporting protrusion, the heat directed toward the center portion of susceptor from the lower halogen lamps is not inhibited, whereby the semiconductor wafer is heated uniformly. Hence, a silicon film having a uniform thickness can be obtained when a normal epitaxial growth process is carried out.

## Description

### Technical Field

The present invention relates to a semiconductor production apparatus having a heating source, such as epitaxial growth apparatus and rapid thermal treatment apparatus; and, in particular, to an improvement in a wafer support for supporting a semiconductor wafer.

### Background Art

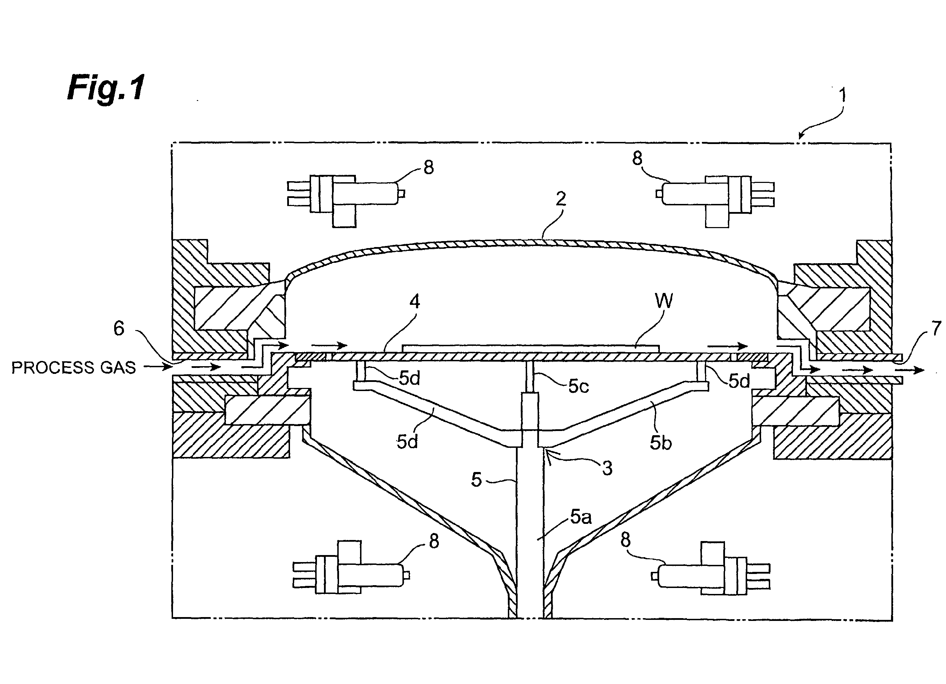

Fig. 1 is a sectional view schematically showing a major-part of an epitaxial growth apparatus 1 which is a conventional semiconductor production apparatus. In Fig. 1, the epitaxial growth apparatus 1 is of a single wafer processing type, which processes semiconductor wafers or silicon wafers W one by one, and comprises a process chamber 2 constituted by silica glass, and a wafer support 3 disposed within the process chamber 2 for supporting a wafer W. The wafer support 3 is constituted by a susceptor 4 having an upper surface for supporting the wafer, and a susceptor support shaft 5 for supporting the susceptor 4. A side portion of the process chamber 2 is formed with an inlet 6 for a process gas, whereas an outlet 7 is formed at a position opposite from the inlet 6. A plurality of halogen lamps 8 are radially disposed in each of areas above and below the process chamber 2.

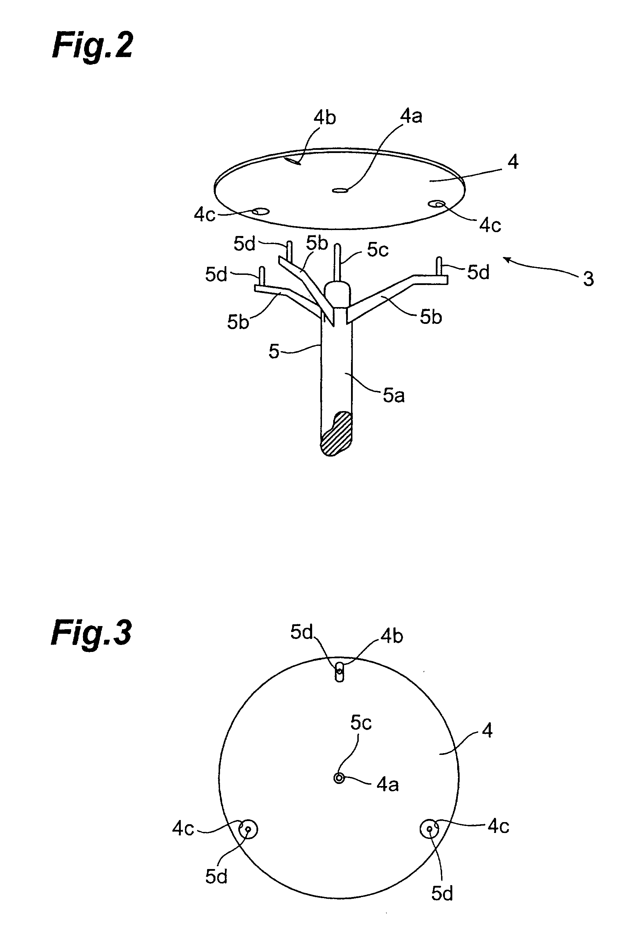

Fig. 2 is a schematic perspective view showing the susceptor 4 and susceptor support shaft 5 of the conventional wafer support 3. Fig. 3 is a bottom plan view of the susceptor 4. As shown in these drawings, the susceptor support shaft 5 is constructed by a main shaft 5a, and three arms 5b arranged at equally spaced intervals in the circumferential direction so as to radially extend from the upper end of the main shaft 5a. The distal ends of the main shaft 5a and the arms 5b are provided with circular-rod-like protrusions 5c and 5d for supporting the susceptor 4, respectively. Also, the lower surface of the susceptor 4 is formed with depressions 4a, 4b, 4c located at the positions corresponding to the protrusions 5c and 5d, respectively. Here, since the susceptor 4 is positioned by the depression 4a formed at the center of the susceptor 4 and the protrusion 5c, the inside diameter of the depression 4a and the outside diameter of the protrusion 5c are substantially identical to each other. Among the three depressions formed in the outer peripheral portion of the susceptor 4, the depression indicated by 4b is shaped into an elongated hole, which has a width identical to the outside diameter of the protrusion 5d for preventing the susceptor 4 from circumferentially moving about the protrusion 5c. The remaining depressions 4c are countersunk holes for simply supporting the susceptor 4, each having an inside diameter greater than the outside diameter of the protrusion 5d.

In the conventional epitaxial growth apparatus 1, which is configured as in the foregoing, a silicon wafer W is initially mounted on the susceptor 4, and then the halogen lamps 8 are lit, so as to heat the silicon wafer W. At the same time, trichlorosilane (SiHCl₃) gas, dichlorosilane (SiH₂Cl₂) gas, or the like, for example, is introduced as a process gas from the inlet 6 while being let out from the outlet 7. Then, the process gas flows in the state of a laminar flow along the surface of the silicon wafer W heated to a predetermined temperature, whereby a single crystal of silicon epitaxially grows on the silicon wafer W.

When a silicon film is formed by use of the conventional epitaxial growth apparatus 1 such as that mentioned above, however, the thickness of silicon film may abruptly drop in the vicinity of the center of silicon wafer W, thus failing to yield a silicon film having a uniform thickness.

Therefore, it is a main object of the present invention to provide an improved semiconductor production apparatus which can yield a film having a uniform thickness, without using additional apparatus.

### Disclosure of the Invention

The inventors have carried out various studies in order to achieve the above-mentioned object and, as a result, have reached a conclusion that the protrusion located under the center of susceptor inhibits the radiant heat from the halogen lamps under the process chamber.

Therefore, the present invention provides a semiconductor production apparatus including a process chamber; a wafer support disposed within the process chamber for supporting a semiconductor wafer; and a heating source, such as halogen lamp, for heat treatment of the semiconductor wafer supported by the wafer support; wherein the wafer support comprises a susceptor having an upper surface for mounting the semiconductor wafer thereon, and a susceptor support shaft for supporting the susceptor from thereunder; wherein the susceptor support shaft having a main shaft positioned substantially coaxial with the center of the susceptor, and at least three arms radially extending from an upper end of the main shaft, each arm having a distal end provided with a protrusion directed toward the susceptor; and wherein a peripheral portion of a lower surface of the susceptor being formed with depressions, each depression having an inside diameter substantially identical to an outside diameter of the protrusion, adapted to engage the protrusion.

According to the present invention, the susceptor has a structure in which it is supported by only the arms extending in its peripheral portion, whereas the protruded part of the susceptor support shaft is not disposed at the lower surface of the center portion of the susceptor, thereby being kept from affecting the heat conduction to the center portion of the susceptor. In particular, the radiant heat from the heating source disposed under the process chamber is not inhibited at the center portion of the susceptor. Therefore, the susceptor and semiconductor wafer, as a whole, are uniformly heated, and a film can be grown with a uniform thickness over the whole surface of the semiconductor wafer. Also, since the positioning is effected by at least three points by the depressions formed at the peripheral portion of the lower surface of the susceptor and the protrusions at the arm ends of the susceptor support shaft, more accurate positioning can be carried out.

Preferably, each depression has an elongated form radially extending in a radial direction of the susceptor. As a consequence, it can absorb the difference in coefficient of thermal expansion between the susceptor and the susceptor support shaft. When the coefficient of thermal expansion of the susceptor is greater than that of the susceptor support shaft in this case, it is preferred that the protrusions engage their corresponding depressions on the outermost peripheral side thereof at ambient temperature.

Preferred as the susceptor is one comprising carbon graphite or silicon carbide. The susceptor may also have a configuration comprising a carbon graphite base and a silicon carbide coating covering a surface of the base. Preferred as the susceptor support shaft is one comprising silica glass.

In the case where the process chamber is provided with an inlet for a process gas and an outlet for letting out the gas from the process chamber, a film can be formed on a surface of a semiconductor wafer by epitaxial growth if the process gas for carrying out an epitaxial growth process is supplied into the process chamber from the inlet.

Preferably, the arms of the susceptor support shaft incline upward as they extend radially outward.

The above-mentioned and other characteristics features and advantages of the present invention will be clear to one skilled in the art by reading the following detailed explanations with reference to the accompanying drawings.

### Brief Description of the Drawings

Fig. 1 is a sectional view schematically showing a conventional semiconductor production apparatus;
Fig. 2 is a schematic perspective view showing a conventional wafer support in a dissembled state;
Fig. 3 is a bottom plan view of a conventional susceptor;
Fig. 4 is a sectional view schematically showing a semiconductor production apparatus in accordance with the present invention;
Fig. 5 is a schematic perspective view showing the wafer support in Fig. 4 in a dissembled state;
Fig. 6 is a bottom plan view showing the susceptor of Figs. 4 and 5;
Fig. 7 is a sectional view taken along the line A-A of Fig. 6; and
Fig. 8 is a graph showing the relationship between the distance from the center of a silicon wafer W and the thickness of silicon film.

### Best Modes for Carrying Out the Invention

In the following, a preferred embodiment of the present invention will be explained in detail with reference to the drawings.

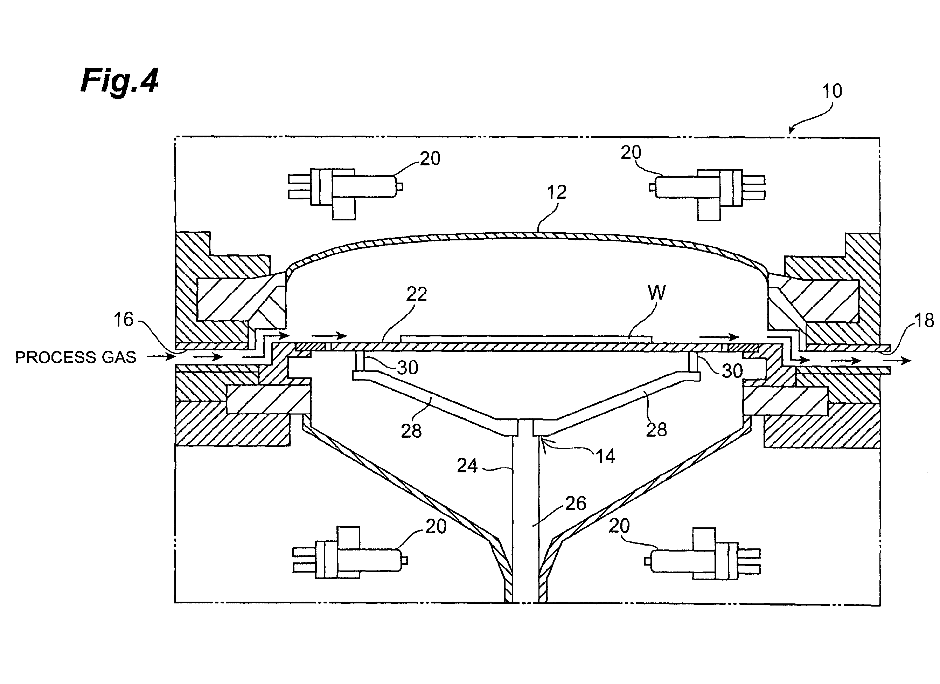

Fig. 4 is a sectional view schematically showing a major-part of an epitaxial growth apparatus 10 in accordance with the present invention. The shown epitaxial growth apparatus 10 is of a single wafer processing type, which processes semiconductor wafers or silicon wafers W one by one, and comprises a process chamber 12 constituted by silica glass, for example, and a wafer support 14 disposed within the process chamber 12 for supporting a wafer W. A side portion of the process chamber 12 is formed with an inlet 16 for a process gas for carrying out epitaxial growth. A process gas source, which is not shown, is connected to the inlet 16. Also, a side portion of the process chamber 12 is formed with an outlet 18 at a position opposite from the inlet 16. A plurality of halogen lamps 20 are radially disposed with an appropriate arrangement in each of areas above and below the process chamber 12.

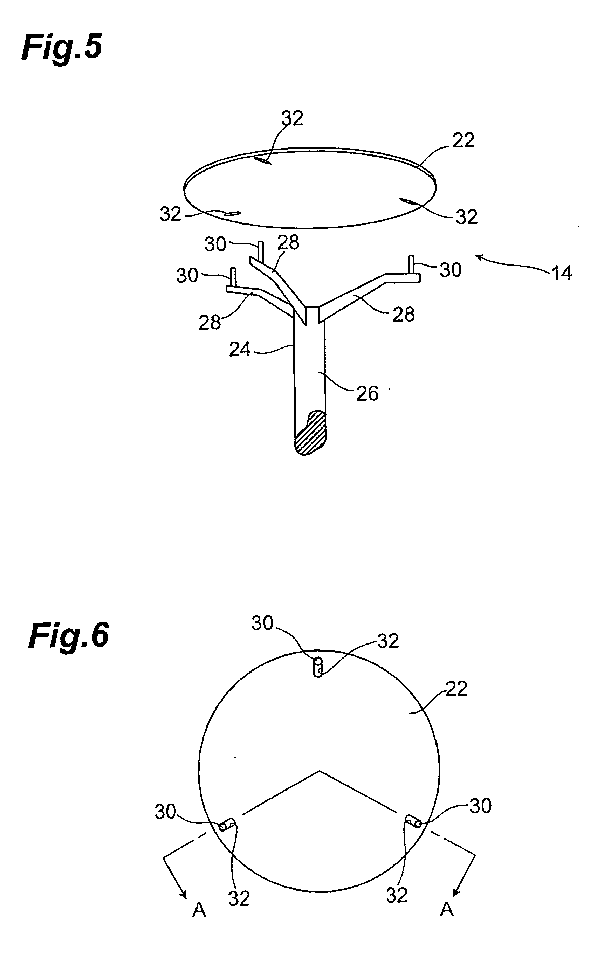

As schematically shown in Fig. 5, the wafer support 14 comprises a flat disk-shaped support plate or susceptor 22. Preferably, the susceptor 22 is formed from carbon graphite. As a matter of course, the susceptor 22 may be made solely of other materials such as silicon carbide, for example, or may be formed from carbon graphite having a surface coated with silicon carbide. The upper surface of the susceptor 22 is formed with an area for resting and supporting the silicon wafer W thereon.

The wafer support 14 comprises a susceptor support shaft 24 for horizontally supporting the susceptor 22. The susceptor support shaft 24 has a main shaft 26, disposed coaxial with the process chamber 12, vertically extending into the process chamber 12 from thereunder. An upper end of the main shaft 26 is integrally formed with three arms 28 radially extending outward. The arms 28 have the same form and are disposed at equally spaced intervals in the circumferential direction. Preferably, each arm 28 inclines upward as it extends outward. The distal end of each arm 28 is integrally formed with a protrusion 30 for resting and supporting the susceptor 22 thereon. Though the shown protrusion 30 is shaped like a circular cylinder as a whole and vertically extends upward, it will be sufficient if at least the upper end portion of the protrusion is shaped like a vertically extending circular cylinder. Preferably, such a susceptor support shaft 24 is integrally formed from silica glass.

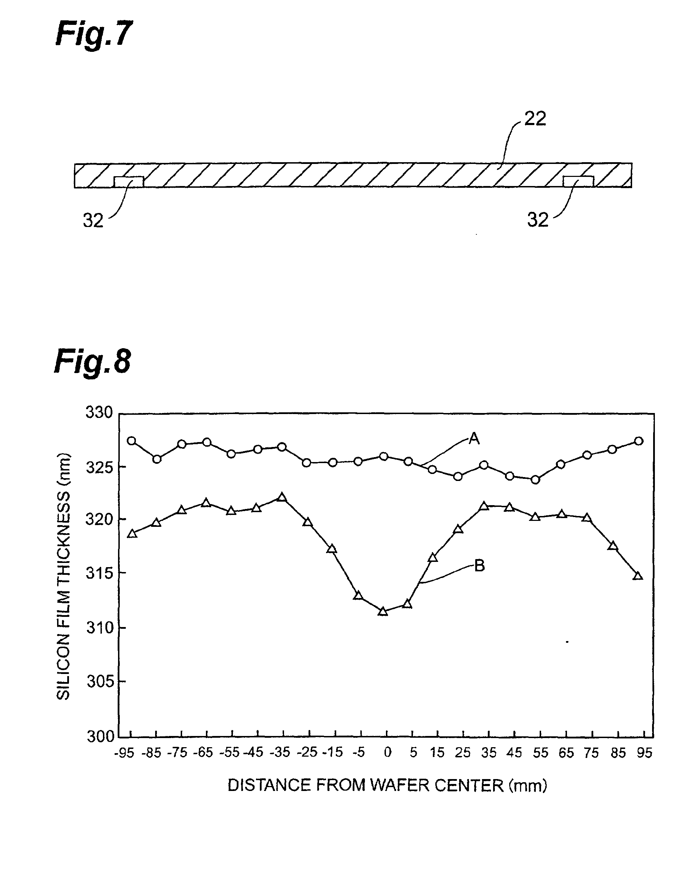

The susceptor 22 can be mounted and supported by the distal end of the above-mentioned protrusion 30. In this supporting state, the susceptor 22 should be disposed concentric with the main shaft 26. Therefore, as shown in Figs. 5 and 6, a depression 32 is formed in the lower surface of the susceptor 22 at the position where the upper end of each protrusion 30 abuts in order to receive the protrusion 30 and limit the movement of the susceptor 22 relative to the susceptor support shaft 24. Though it is not particularly necessary to specify the depth of the depression 32 since it will be sufficient if the depression 32 can limit the horizontal movement of the susceptor 22, the depth is preferably about half the thickness of the susceptor 22 as shown in Fig. 7 in order to securely prevent the protrusion from separating out of the depression 32.

Since the positioning of the susceptor 22 with respect to the susceptor support shaft 24 is effected by the depressions 32 formed at the peripheral portion of the lower surface of the susceptor 22 and the protrusions 30 as mentioned above, it will be sufficient if the inside diameter of depression 32 and the outside diameter of the leading end portion of protrusion 30 are substantially identical to each other. However, if the depression 32 has a circular cross-sectional form identical to that of the protrusion 30, then there is a fear of a mechanical load being applied to the susceptor 22 and/or the susceptor support shaft 24 when the coefficient of thermal expansion greatly differs between the susceptor 22 and the susceptor support shaft 24. Therefore, for absorbing the difference in coefficient of thermal expansion between the susceptor 22 and the susceptor support shaft 24, it is desirable that the depression 32 is formed as an elongated groove extending in the radial direction of the susceptor 22. While the width of the groove 32 is substantially identical to the diameter of the protrusion 30 in order to prevent the susceptor 22 from circumferentially moving, the groove 32 and the protrusion 30 are required to have such dimensions that, when heat is applied thereto, the protrusion 30 can slide within the groove 32 in the radial direction, i.e., in the longitudinal direction of the groove 32. In addition, when the susceptor support shaft 24 is made of silica glass while the susceptor 22 is made of carbon graphite having a coefficient of thermal expansion greater than that of silica glass, for example, it is desirable that the protrusion 30 is positioned on the outermost peripheral side of the depression 32 as shown in Fig. 6 at ambient temperature. With this arrangement, since the susceptor 22 is supported and positioned by the three protrusions 30 of the susceptor support shaft 24, more accurate positioning can be obtained.

When forming a silicon film by use of thus configured epitaxial growth apparatus 10, a silicon wafer W is initially mounted on a predetermined area on the susceptor 22. Thereafter, the halogen lamps 20 are lit to heat the silicon wafer W. At the same time, trichlorosilane (SiHCl₃) gas, dichlorosilane (SiH₂Cl₂) gas, or the like, for example, is introduced as a process gas from the inlet 16 while being let out from the outlet 18. Then, the process gas flows in the state of a laminar flow along the surface of the silicon wafer W heated to a predetermined temperature, whereby a single crystal of silicon epitaxially grows on the silicon wafer W.

When the conventional wafer support shown in Figs. 1 to 3 is used, it is expected that the radiant heat from the halogen lamps disposed under the process chamber is inhibited by the center protrusion 5c, whereby the temperature at the center portion of the susceptor 22 will be lower than that at the other portions. on the contrary, since the wafer support 14 in accordance with the present invention has no protrusion for supporting the center of the susceptor 22, the radiant heat from the halogen lamps 20 is securely transmitted to the center portion of the susceptor 22 as well. Therefore, the susceptor 22 and the silicon wafer W as a whole are uniformly heated, whereby a silicon film having a uniform thickness is formed over the whole surface of the wafer W.

Upon heating, the susceptor 22 and the susceptor support shaft 24 expand at respective ratios different from each other. Namely, the susceptor 22 made of carbon graphite expands greater than the susceptor support shaft 24 made of silica glass does. However, since each depression 32 shaped like an elongated groove extends in the radial direction of the susceptor 22 while the three depressions are disposed at equally spaced intervals in the circumferential direction, only the protrusion relatively moves toward the center within the depression 32 even when there is a difference of expansion between the susceptor 22 and the shaft 24, whereby the center point of the susceptor 22 is kept on the center axis of the main shaft 26.

Fig. 8 is a graph showing, in the case where a 200-mm silicon wafer W is used for forming a silicon film upon epitaxial growth by way of example, the relationship between the distance from the center point of silicon wafer W and the thickness of silicon film. Curve A indicates the results obtained when the wafer support in accordance with the present invention was used, whereas curve B indicates the results obtained when a wafer support of a conventional type having a protrusion at the center thereof was used. From curve B of this graph, it is seen that the film thickness abruptly decreases in the vicinity of the center of wafer W in the conventional wafer support. By contrast, it is seen from curve A that no fluctuation in film thickness is observed even in the vicinity of the center of wafer W in the wafer support of the present invention, whereby an epitaxially grown silicon film having a substantially uniform thickness can be obtained. It is presumed to be because of the fact that, since no protruded part exists under the center of susceptor 22 in accordance with the present invention, the film is grown in a state where the silicon wafer W is uniformly heated without inhibiting the radiant heat of the halogen lamps 20 from under the process chamber 12.

Though the case where an epitaxial growth apparatus is used as a semiconductor production apparatus is explained in the above-mentioned embodiment, the present invention is not restricted thereby and is applicable to various semiconductor production apparatus such as rapid heat treatment annealing apparatus and thermal CVD apparatus. For example, a uniform film can be obtained in a rapid heat treatment annealing apparatus since temperature becomes constant over the whole surface of wafer.

Though the case where the susceptor support shaft has three arms is explained in the above-mentioned embodiment, four or more arms can be used as well.

### Industrial Applicability

An improved wafer support of the present invention comprises a susceptor and a unique susceptor support shaft as explained in the foregoing, whereby the center of susceptor mounting a semiconductor wafer can be heated without inhibiting the radiant heat of a heating source such as halogen lamp from under the process chamber. As a consequence, it yields an effect that an epitaxially grown silicon film having a uniform thickness is obtained. Also, since the positioning is effected by at least three points by the depressions formed at the peripheral portion in the lower surface of susceptor and the protrusions of arm ends of susceptor support shaft, it yields an effect that more accurate positioning can be carried out.

Further, the whole surface of a semiconductor wafer can be subjected to uniform heat treatment in other heat treatment apparatus as well, since there are no objects in contact with the center portion of semiconductor wafer and, consequently, no heat conduction to the center portion is affected thereby.

As a result, the present invention can respond to higher integration and miniaturization of devices in the field of making electro-micro devices such as semiconductor device.

## Claims

1. A semiconductor production apparatus including a process chamber; a wafer support disposed within said process chamber for supporting a semiconductor wafer; and a heating source for heat treatment of the semiconductor wafer supported by said wafer support;
wherein said wafer support comprises a susceptor having an upper surface for mounting said semiconductor wafer thereon, and a susceptor support shaft for supporting said susceptor from thereunder; wherein said susceptor support shaft having a main shaft positioned substantially coaxial with a center of said susceptor, and at least three arms radially extending from an upper end of said main shaft, each said arm having a distal end provided with a protrusion directed toward said susceptor; and wherein a peripheral portion of a lower surface of said susceptor being formed with depressions, each said depression having an inside diameter substantially identical to an outside diameter of said protrusion, adapted to engage said protrusion.

2. A semiconductor production apparatus according to claim 1, wherein said heating source is disposed under said susceptor.

3. A semiconductor production apparatus according to claim 1 or 2, wherein said depression has an elongated form extending in a radial direction of said susceptor.

4. A semiconductor production apparatus according to claim 3, wherein said protrusion is engaged in said depression on the outermost peripheral side thereof at ambient temperature when said susceptor has a coefficient of thermal expansion greater than that of said susceptor support shaft.

5. A semiconductor production apparatus according to claim 1, wherein said susceptor comprises carbon graphite.

6. A semiconductor production apparatus according to claim 1, wherein said susceptor comprises carbon graphite having a surface coated with silicon carbide.

7. A semiconductor production apparatus according to claim 1, wherein said susceptor comprises silicon carbide.

8. A semiconductor production apparatus according to claim 1, wherein said susceptor support shaft comprises silica glass.

9. A semiconductor production apparatus according to claim 1, wherein said process chamber comprises an inlet for a process gas, and an outlet for letting out the gas from said process chamber.

10. A semiconductor production apparatus according to claim 9, wherein said process gas is a gas for carrying out an epitaxial growth process.

11. A semiconductor production apparatus according to claim 1, wherein said arm inclines upward as said arm extends radially outward.
